Europäisches Patentamt

European Patent Office

Office européen des brevets

(19)

(11) Publication number: **0 178 162**
A1

# (12) EUROPEAN PATENT APPLICATION

(21) Application number: 85307224.7

(22) Date of filing: 09.10.85

(51) Int. Cl.⁴: **H 01 L 21/68**, B 23 P 23/00,
B 65 G 37/02

(30) Priority: 12.10.84 GB 8425850

(43) Date of publication of application: 16.04.86
Bulletin 86/16

(84) Designated Contracting States: **AT BE CH DE FR GB IT
LI NL SE**

(71) Applicant: **South London Electrical Equipment Company
Limited, Lanier Works Hither Green Lane, London
SE13 8QD (GB)**

(72) Inventor: **Hill, Terence Albert, 6 Southcroft Avenue, West
Wickham Kent BR4 9JX (GB)**

(74) Representative: **JENSEN & SON, 8 Fulwood Place High
Holborn, London WC1V 6HG (GB)**

(54) Apparatus for feeding components through a work station.

(57) The apparatus for feeding electrical components through
a work station includes an elongate magazine (17) for a plurality
of components having indicia (32, 59) for each component. The
magazine is driven through the station by a conveyor system
(31, 50, 51) driven by a stepper motor (36) through a reduction
box. The motor (36) is controlled through electronic control cir-
cuitry including a sensor (43-45, 56) responsive to the indicia
to index the magazine (17) through the work station.

EP 0 178 162 A1

- 1 -

Apparatus for feeding components
through a work station

This invention relates to apparatus for feeding components through a work station and has particular, but not exclusive, application to feeding semi-conductor components to and from machines on a fully automated production line. In such production lines, the individual components are small and required to be moved through the machines at high speed. The speed at which the components must be moved into and out of the processing machines, coupled with their small size, leads to great problems in handling the components and, particularly, in their accurate location in each machine for the processing operations to be carried out.

The present invention seeks to provide an improved method and apparatus for accurately locating components in a work station.

According to the present invention, in its broadest aspect, there is provided apparatus for feeding components through a work station, including an elongate magazine for carrying a plurality of linearly spaced components, an elongate support surface adapted to support the magazine for transport through the work station, said magazine being engageable with co-operative drive conveyor means thereby to entrain the magazine, movement of the drive conveyor means transporting the entrained magazine through the work station, drive means to drive the drive conveyor means and control means responsive to the presence of a magazine to control the progress of the magazine through the work station and to stop the magazine at a predetermined position or positions in the work station.

Preferably, the drive means comprises a stepper motor, which may be connected to the drive conveyor means through a mechanical reduction system. By this means,

- 2 -

the position or positions at which the magazine is stopped in the work station can be determined accurately.

In one preferred embodiment of the invention, the drive conveyor means comprises a flexible endless belt conveyor having teeth on both its inner surface and its outer surface, the teeth on the inner surface engaging in corresponding teeth in drive sprockets, at least one of which is driven by the drive means, the teeth on the outer surface engaging corresponding teeth on the magazine.

In another embodiment the drive conveyor means comprises a first flexible endless belt conveyor adapted to be driven by said drive means and adapted to frictionally engage one side of a magazine, a second flexible endless belt conveyor parallel to said first conveyor and adapted to frictionally engage an opposite side of a magazine, and means to resiliently bias the two conveyors one towards the other.

The preferred embodiment will now be described by way of example with reference to the accompanying drawings in which:-

Figure 1 shows a component on which a production process is to be carried out,

Figure 2 shows a general view of the work sation,

Figure 3 shows a plan view of the work station showing the means for driving components through the station,

Figure 4 shows a side view of Figure 3,

Figure 5 shows a section along the line A-A shown in Figure 3.

Figure 6 shows a plan view similar to Figure 3 of another embodiment of the invention in which like parts have like reference numerals, and

Figure 7 shows a schematic view of a position sensor incorporated in the embodiment of Figure 6.

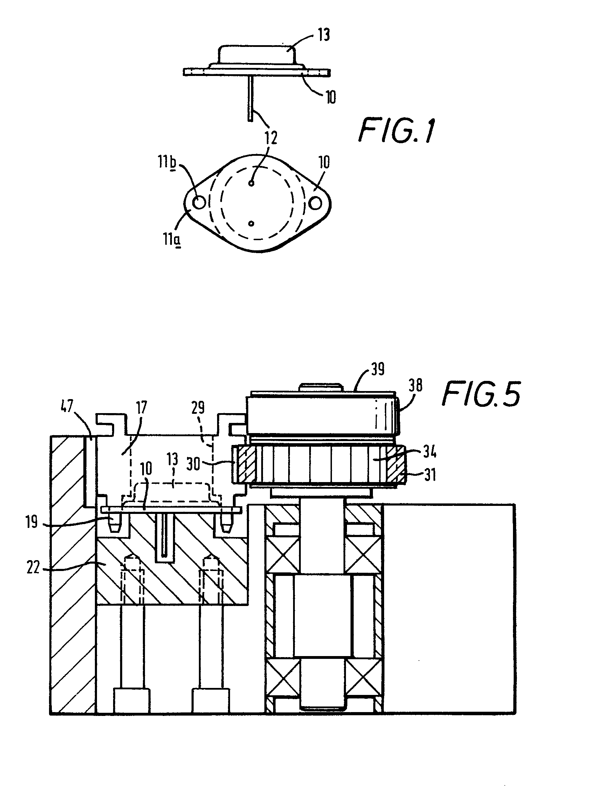

Referring now to Figure 1, there is shown the outline of a standard encapsulated transistor device bearing the JEDEC reference TO-3. The embodiment of the present invention to be described is intended specifically for the manufacture and assembly of this device but it will be understood that the apparatus of the present invention may be used to control the passage of other types of component, and the magazine containing the components, and is not to be regarded as limited to the manufacture of semi-conductor transistors.

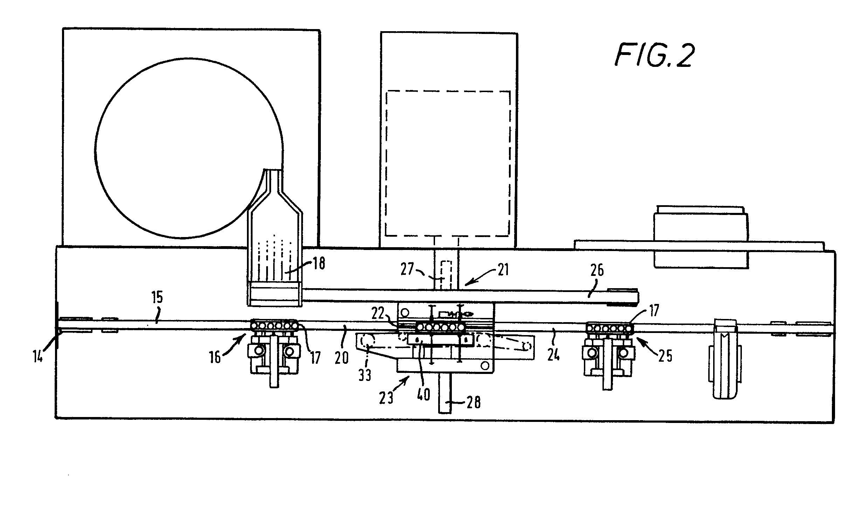

In the manufacture of such transistors, a plurality of steps are involved which require the transistor to be sent through a number of machines automatically for the various process steps to be carried out; the general arrangement drawing shown in Figure 2 comprises a welding station for encapsulating the transistors.

As shown in Figure 1 the transistor consists of a base 10 having two flanges 11a containing bores 11b by which the transistor may be secured in its ultimate assembly. The actual semi-conductor component itself is mounted on the base and its electrical connections, comprising two pins 12, project through the base. The semi-conductor device is encapsulated by a cap 13, of top hat section, which is circular in plan and which is welded to the base by an electric welding process.

Referring now to Figure 2, there is shown a welding station in which the caps 13 are welded to the bases 10 by an electric welding system. The transfer of the components through the work station is achieved by apparatus in accordance with the present invention which will be described in greater detail hereinafter. The welding process does not form part of the present invention and it will be appreciated that the transport apparatus may be adapted for use in other process steps,

- 4 -

being described here only for information.

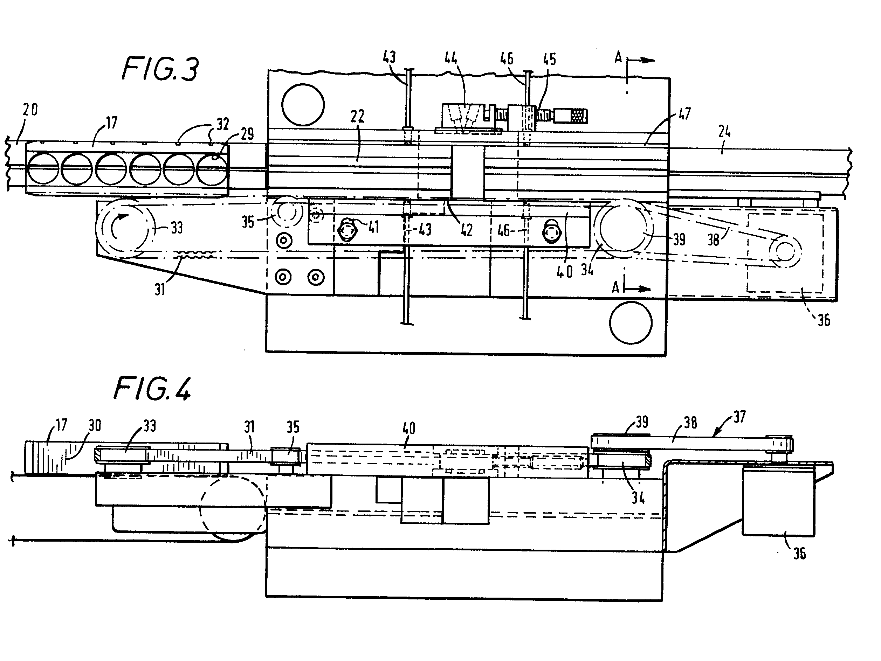

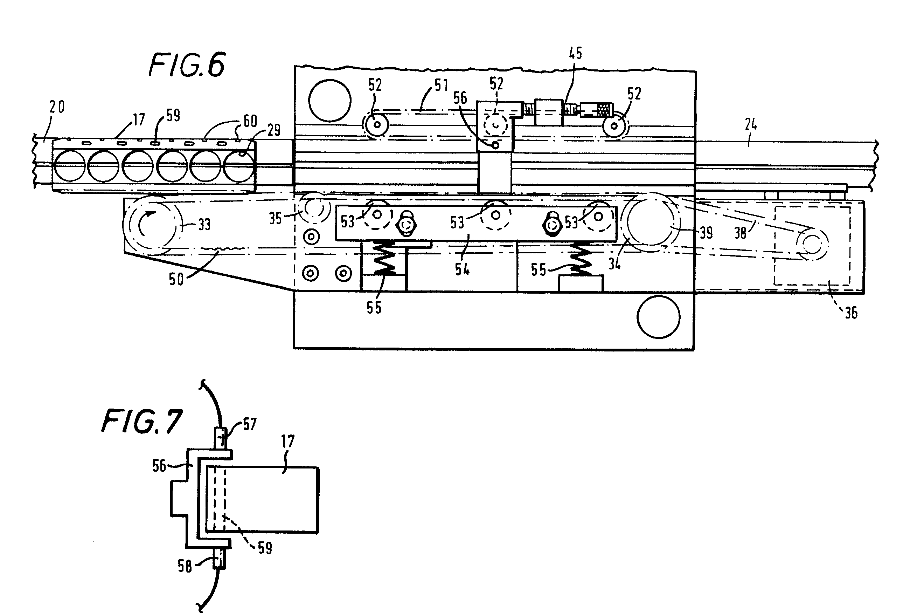

The work station includes a closed container 14 within which a "clean" environment is maintained, typically by the use of nitrogen atmosphere. The semiconductor devices on the bases 10 are supplied to the welding station from an oven (not shown) through an airlock 14 and are conveyed, linearly aligned, along a conveyor to a pick and place loading sub-station 16. In the sub-station 16, six of the bases 10 are aligned to be loaded into a magazine 17. The magazine 17 already has a corresponding number of caps 13 loaded therein by a cap feed assembly 18 where caps are placed into the magazine. The magazine then is placed on top of the bases 10. The magazine, as shown in Figure 5, incorporates a corresponding number of pairs of pins 19 which engage in the securing bores 11b in the flanges 11a of the bases to thereby accurately locate the bases in the magazine. The loaded magazine 17 is then transported on a movable conveyor belt 20 into the welding machine 21. In the region of the welding machine 21, the magazine is supported on a fixed surface 22 and is transported through the welding machine 21 by a drive arrangement 23 described in greater detail with reference to Figure 3 and 4. From the welding machine, the magazine carrying the components which have been welded is transferred onto a further moving conveyor 24 to an unloading station 25 where the completed components are removed from the magazine. The empty magazine 17 is then transferred to a transfer conveyor 26 for transfer back to the cap feed assembly 18. The welding machine 21 is a conventional electric welding machine having one electrode 27 above the magazine which contacts the cap 13 and a second welding electrode 28 which lies underneath the supporting surface 22 to complete the electrical welding circuit.

- 5 -

Referring now to Figures 3, 4 and 5, the manner in which the magazine is transported through the welding station will now be described in greater detail. The magazine 17 can be formed of a synthetic plastics material such as TUFNOL which is electrically non-conductive or from copper which then has to move between insulated guides 47. The illustrated embodiment is designed to receive six components but can have as many as required. It therefore has six openings 29 linearly spaced and electrically insulated from each other by the main body of the magazine. Along one of its side faces, the magazine 17 carries a rack 30 of teeth which are adapted to mate with teeth in an outer surface of a drive conveyor 31. The teeth of the rack 30 may be moulded or machined in the plastic body of the magazine 17 or may be, for example, a length of conveyor belt material secured to the magazine 17. On its other side, at least, the magazine carries indicia located accurately to the centre-line of the component position 32 which serve to indicate the presence of a magazine in the apparatus and the position of each opening, to a high degree of accuracy, in the magazine. The purposes of the indicia will be described later.

The drive conveyor 31 consists of a flexible belt having, as described earlier, teeth on its outer surface for driving the magazine and similar teeth on its inner surface for driving engagement with drive sprockets 33 and 34. An idler sprocket 35 is located intermediate the main drive sprockets 33 and 34 and serves, in cooperation with the drive sprocket 34 to maintain the belt in alignment with the path of magazines 17 through the machine and in conjunction with the drive sprocket 33 serves to provide a lead-in angle from the said path so that the teeth on the magazine and on the conveyor belt 31 gradually merge. This serves to ensure that the teeth mesh correctly.

0178162

- 6 -

The belt 31 is driven by an electric stepper motor 36 which is connected to a reduction belt drive system 37 which consists of a toothed belt 38 driving a sprocket 39 coaxial with the drive sprocket 34 and rotationally fast thereto. It is possible that the stepper motor 36 may be connected through a reduction gear to the shaft of the drive sprocket 34 to drive the drive sprocket 34 directly but it is preferred that the motor 36 and its related control system is based some way from the welding machine to prevent the inevitable field from the welding current from affecting the operation of the motor or its control gear.

Between the drive sprocket 34 and the idler sprocket 35, the belt 31 lies in a path parallel to the path of the magazine 17 through the work station. In order to ensure that the conveyor belt, which is, of course, flexible, is maintained in the correct alignment with the magazine a guide plate 40 is provided slidably mounted in slots 41 transverse to the aforementioned paths so that the position of the face 42 of the plate 40 against which the inner surface of the conveyor belt 31 abuts, can be positioned to ensure that complete engagement is maintained throughout this length of the conveyor between the teeth on the conveyor belt and the teeth on the side of a magazine 17 the magazine being urged against the fixed guide 47. The member 40 is clamped in the desired position.

The control system of the apparatus utilises fibre optics rather than electrical sensors to reduce risk of the control system being affected by the magnetic field of the welding current, whilst also providing higher reliability and improved, consistent performance.

When a magazine is transported by the conveyor 20 into the welding station, it is picked up by the conveyor belt 31 at the end of the conveyor 20 and carried by the conveyor belt 31 at a constant speed into the work station. When the presence of a magazine is detected by a first fibre optic system 43, the speed of the motor and hence the speed of the conveyor belt 31 is reduced from a first, high level, to a low level. The high and low motor speeds can be set as required for different magazine sizes, different component feed rates and different component sizes. The magazine is then transported slowly until the back edge of the first indicia 32 on the magazine is detected by a further fibre optic detection system 44. The fibre optic system 44 is arranged to send a signal to the control system of the motor 36 to stop the motor immediately the indicia 32 is detected. The precise position of the fibre optic system 44 is adjustable by a Vernier scale adjuster 45 so that when the motor is stopped the magazine is aligned precisely with the semi-conductor component in the first opening 29 in the magazine 17 so that the component is accurately aligned with the electrodes of the welding apparatus. The Vernier scale 45 is usually set when the apparatus is first set up and thereafter no adjustment is usually necessary. A further fibre optic system 46 is provided to detect when a magazine leaves the welding station. When this point is detected, and if no further magazines are detected at the first sensing point the speed of the stepper motor 36 is immediately increased to a high level and the magazine is quickly transported to the unloading station referred to earlier.

By providing the accurate drive system incorporating the flexible toothed conveyor belt 31 in conjunction with the stepper motor 36 and reduction gearbox, it is possible to index the movement of the conveyor belt 31 through greater than 2000 steps for each revolution of the stepper motor 36 is required, the precise step at which the motor and hence the magazine is stopped being determined by the associated control system. The stepper motor itself may typically provide

- 8 -

in the region of 200 steps per revolution and this number can be magnified by at least 10 through the mechanical reduction system and the electronic controller. In this way, the position of a magazine in the work station can be very accurately determined to ensure that the encapsulated semi-conductor components contained in the magazine are positioned accurately between the electrodes of the welding apparatus to enable a satisfactory weld to be made, whilst at the same time enabling high speed processing of the components to be achieved.

Figure 6 illustrates an alternative embodiment in which the driving force for driving the magazine 17 through the work station is generated frictionally. The drive conveyor consists of a flexible endless belt 50 having a toothed inner face for positive driving engagement with the drive sprockets 33, 34 and a plane outer surface adapted to frictionally engage the side of a magazine 17.

As in the previous embodiment the drive conveyor has a lead-in section between the sprockets 33 and 35 and a straight section extending through the work station between sprockets 35 and 34.

On the opposite side of the path 20 there is a second flexible endless conveyor 51 extending along the side of the path 20 throughout the work station. The conveyor 51 is located by a plurality of idler rollers 52, three being shown, so that the conveyor 51 serves as an abutment for the magazines passing through the work station but since it is able to move freely by virtue of the idler rollers 52 no sliding friction is generated.

To ensure adequate frictional engagement between the drive conveyor 50 and the magazines 17, the straight section of conveyor 50 extending through the work station is resiliently biassed towards the the second conveyor. To this end, a plurality of idler rollers 53 are mounted in an elongate carrier block 54 so as to abut the inner face of the drive conveyor. The carrier block 54 is slidable towards and away from the path 20 and is biassed towards the path by springs 55.

The magazines 17 in this embodiment need not have the toothed rock 30. On entering the work station the magazine is entrained frictionally by the lead-in portion of the drive belt and driven into the work station where it enters between the two conveyor belts 50, 51 for positive driving engagement as it is stepped through the station. The resilient force generated by the springs 55 is adjustable to ensure that sufficient frictional forces between the conveyors and the magazines are generated to eliminate slip.

Deletion of a magazine 17 is made by an optical sensor 56, also shown in Figure 7, the precise position of which can be adjusted by the Vernier scale 45, as previously described. The sensor 56 consists of an emitter 57 and a receptor 58 located respectively above and below a magazine in the work station. When the sensor first detects the presence of a magazine, the electronic control system switches the drive to slow speed, if this is required, and indexes the magazine through the station. The optical signal or beam from the emitter 57 to the receptor 58 is interrupted by the body of the magazine. In this embodiment, the magazine has appropriately spaced aligned bore or slots 59 each associated with a respective component so that as a slot is aligned with the sensor a signal is received by the receptor 58 and transmitted to the control system to initiate a welding operation.

The detection of the end of a magazine is also determined by or transmitted to the control system,

- 10 -

by for example the correct number of welds per magazine having been carried out, or by the receptor 58 receiving a signal from the emitter for more than a predetermined length of time.

Instead of the slot 59, the signal from the emitter 57 may pass through grooves 60 milled in the side of the magazine.

Although described with reference to a welding station, it will be appreciated that the apparatus of the present invention may be incorporated in any work station where it is desired to quickly and accurately align relatively small components, although it does have particular application to the processing of semi-conductor devices in high speed fully automated processing plants.

It is also possible to operate all the conveyor motors in the system together. Each conveyor will need to have a respective stepper motor to drive it. All of the stepper motors would be controlled by the one electronic controller. This could then automatically stop, start, run at high and low speeds all the conveyors in the system.

CLAIMS:

1.     Apparatus for feeding components through a work station, including an elongate magazine for carrying a plurality of linearly spaced components, an elongate support surface adapted to support the magazine for transport through the work station, said magazine being engageable with cooperative drive conveyor means thereby to entrain the magazine, movement of the drive conveyor means transporting the entrained magazine through the work station, drive means to drive the conveyor, and control means responsive to the presence of a magazine to control the progress of the magazine through the work station and to stop the magazine at a predetermined position or positions in the work station.

2.     Apparatus according to claim 1 wherein the drive means comprises a stepper motor, the control means being such as to stop the motor at a predetermined step in its rotational cycle in response to a signal indicative of the position of the magazine.

3.     Apparatus according to claim 2 wherein the stepper motor is connected to the drive conveyor through a reduction gear system.

4.     Apparatus according to any one of claims 1 to 3 wherein the drive conveyor means comprises a flexible endless belt conveyor having teeth on both its inner surface and its outer surface, the teeth on the inner surface engaging in corresponding teeth in drive sprockets, at least one of which is driven by the drive means, the teeth on the outer surface engaging corresponding teeth on the magazine.

5.    Apparatus according to any one of claims 1 to 3 wherein the drive conveyor means comprises a first flexible endless belt conveyor adapted to be driven by the drive means and adapted to frictionally engage one side of a magazine, a second flexible endless belt conveyor parallel to said first conveyor and adapted to frictionally engage an opposite side of the magazine, and means to resiliently bias the two conveyors one towards the other so as to frictionally grip a magazine therebetween.

6.    Apparatus according to any one of claims 1 to 5 wherein the magazine includes a plurality of indicia means each associated with a respective component location in the magazine.

7.    Apparatus according to claim 6 wherein the control means includes a sensor means responsive to the presence or absence of a magazine.

8.    Apparatus according to claim 6 or 7, further comprising sensor means responsive to the presence of an indicia means to stop transportation of the magazine for a work cycle, the control means re-initiating transport after completion of the work cycle transportation being stopped when the presence of the next succeeding indicia means is detected, to thereby index the magazine through the work station.

9.    Apparatus according to claim 6,7 or 8 wherein each indicia means has a leading edge, detection of which initiates a reduction in transportation speed of the magazine, and a trailing edge, detection of which initiates stopping of the magazine.

- 13 -

10.    Apparatus according to any one of the preceding claims wherein the control means, when the presence of a magazine is detected, reduces the speed of transportation.

*FIG.1*

*FIG.5*

0178162

FIG.2

FIG.3

FIG.4

3/4

0178162

*FIG.6*

*FIG.7*

European Patent
Office

**EUROPEAN SEARCH REPORT**

Application number

| | **DOCUMENTS CONSIDERED TO BE RELEVANT** | | EP 85307224.7 |
|---|---|---|---|

| Category | Citation of document with indication, where appropriate, of relevant passages | Relevant to claim | CLASSIFICATION OF THE APPLICATION (Int. Cl.4) |
|---|---|---|---|
| X | EP - A2 - 0 076 231 (SCHÄFER)<br>* Page 7, lines 1-18; claim 2; fig. 1,2 *<br>-- | 1 | H 01 L 21/68<br><br>B 23 P 23/00<br><br>B 65 G 37/02 |
| X | US - A - 4 209 898 (AOKI) | 1 | |
| A | * Column 1, lines 41-62; claims 1,2,4,5,8 *<br>-- | 4,7 | |
| A | EP - A2 - 0 106 595 (YANG, TAI-HER)<br>* Page 11, lines 1-20; page 37, lines 2-7; page 47, line 7 - page 48, line 5; fig. 16,52,53 *<br>-- | 1-4 | |
| A | CH - A5 - 595 939 (HUTT)<br>* Column 1, line 51 - column 2, line 24; claim; fig. *<br>-- | 1,4 | **TECHNICAL FIELDS SEARCHED (Int. Cl.4)** |
| A | US - A - 4 417 396 (AMMON)<br>* Column 2, lines 27-40; column 8, lines 39-41; fig. 13-15 *<br>-- | 6,8 | B 08 B<br>B 23 P<br>B 65 G<br>H 01 L |
| A | FR - A - 2 498 813 (INSTRUMENTS)<br>* Fig. 5; claim *<br>-- | | |
| A | DE - A - 2 164 390 (CITIZEN)<br>* Page 1, lines 5-9; claims; fig. 1 *<br>-- | | |

The present search report has been drawn up for all claims

| Place of search | Date of completion of the search | Examiner |
|---|---|---|
| VIENNA | 13-01-1986 | HEINICH |

**European Patent Office**

**EUROPEAN SEARCH REPORT**

Application number

| | DOCUMENTS CONSIDERED TO BE RELEVANT | | EP 85307224.7 |
|---|---|---|---|

| Category | Citation of document with indication, where appropriate, of relevant passages | Relevant to claim | CLASSIFICATION OF THE APPLICATION (Int. Cl.4) |
|---|---|---|---|
| A | <u>DE - B2 - 2 100 881</u> (BOSCH)<br>* Claims; fig. *<br><br>---- | | |
| | | | **TECHNICAL FIELDS SEARCHED (Int. Cl.4)** |

The present search report has been drawn up for all claims

| Place of search | Date of completion of the search | Examiner |
|---|---|---|
| VIENNA | 13-01-1986 | HEINICH |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82